## Europäisches Patentamt

## European Patent Office

## Office européen des brevets

(19)

(11) Veröffentlichungsnummer: **0 226 050**
**B1**

(12) # EUROPÄISCHE PATENTSCHRIFT

(45) Veröffentlichungstag der Patentschrift:
**27.06.90**

(51) Int. Cl.⁵: **H01L 21/60**

(21) Anmeldenummer: **86115782.4**

(22) Anmeldetag: **13.11.86**

(54) **Verfahren zum Aufbringen eines IC auf ein Substrat.**

(30) Priorität: **11.12.85 DE 3543643**

(43) Veröffentlichungstag der Anmeldung:
**24.06.87 Patentblatt 87/26**

(45) Bekanntmachung des Hinweises auf die Patenterteilung:
**27.06.90 Patentblatt 90/26**

(84) Benannte Vertragsstaaten:
**CH DE FR GB LI NL**

(56) Entgegenhaltungen:
**EP-A- 0 103 889**
**EP-A- 0 111 734**
**FR-A- 2 535 110**
**US-A- 4 300 715**

**ELECTRONIQUE ET APPLICATIONS INDUSTRIELLES,
Nr. 260, November 1978, Seiten 29-32, Paris, FR; A.
ROUALET: "Microcircuits sur film KAPTON: circuits
intégrés sur bande"**

(73) Patentinhaber: **Licentia Patent-Verwaltungs-GmbH,
Theodor-Stern-Kai 1, D-6000 Frankfurt/Main 70(DE)**

(72) Erfinder: **Fahrenschon, Kurt, Hirschstrasse 8,
D-7914 Pfaffenhofen(DE)**

(74) Vertreter: **Amersbach, Werner, Dipl.-Ing. et al, Licentia
Patent-Verwaltungs-GmbH Theodor-Stern-Kai 1,
D-6000 Frankfurt 70(DE)**

**Beschreibung**

Die vorliegende Erfindung betrifft eine Verfahren nach dem Oberbegriff des Patentanspruches 1. Ein solches Verfahren ist aus der EP-A 0 111 734 bekannt.

Die Verwendung eines leitfähigen Klebers zum elektrischen Verbinden der Leiterbahnen von IC's tragenden Bauteilen mit den Leiterbahnen auf dem Substrat einer Flüssigkristall-Anzeigezelle (FK-Zelle) ist z. B. aus der DE-A 32 43 227 bekannt (= EP-A 0 111 734).

Der vorliegenden Erfindung liegt die Aufgabe zugrunde, ein für eine automatisierte Fertigung besonders geeignetes Verfahren zum Aufbringen und Klebekontaktieren von IC's auf insbesondere aus Glas bestehenden Substraten anzugeben.

Diese Aufgabe wird durch die im Kennzeichen des Patentanspruches 1 angegebenen Merkmale gelöst.

Durch das beschriebene Direktaufbringen von leitfähigem Kleber auf die Leiterbändchen des IC im Bereich des aus Isoliermaterial bestehenden Rahmens wird wesentlich die Gefahr verringert, daß durch den leitfähigen Klebstoff zwischen benachbarten Leiterbahnen oder Leiterbändchen unerwünschte leitfähige Brücke entstehen. Das direkte Aufbringen des Klebstoffes erfolgt dabei mittels Siebdrucken oder mittels einer Dosierspritze.

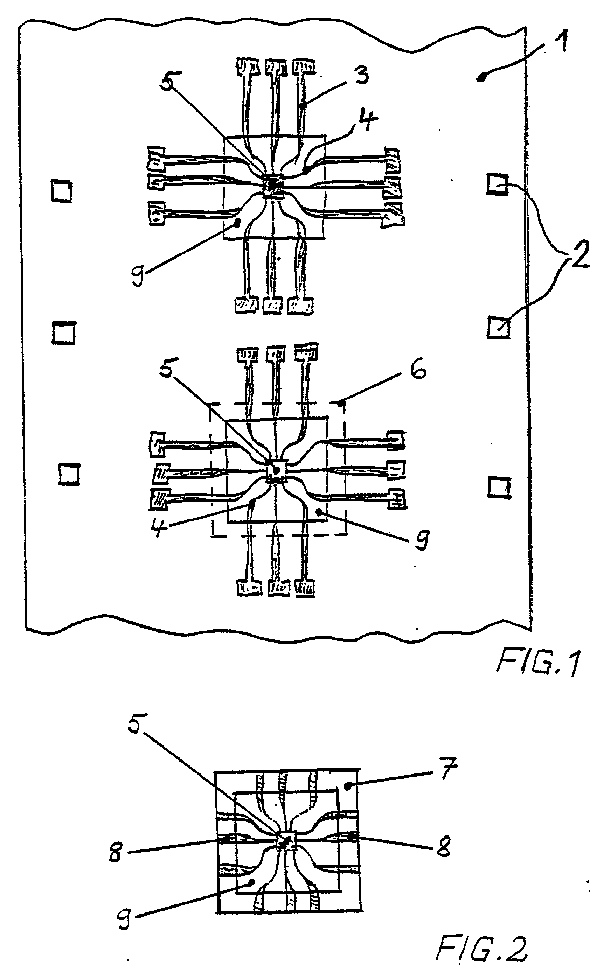

Anhand der in den Figuren 1 bis 10 dargestellten Ausführungsbeispiele wird die Erfindung nachfolgend näher erklärt.

Die dargestellten Ausführungsbeispiele zeigen zum Teil einzelne Verfahrensschritte und zum Teil Alternativausführungen der Erfindung.

Die Figur 1 zeigt zunächst einen an sich bekannten Film mit IC's von dem ein Ausschnitt dargestellt ist. Der Film 1 besteht aus einem Isoliermaterial und weist zweckmäßig am Rand Markierungen 2 auf, z. B. in Form von Durchbrüchen, die in exakter geometrischer Beziehung zu den IC's auf dem Film stehen. Dieser Film weist in Aneinanderreihung eine Vielzahl von IC's auf, die über Öffnungen 9 in dem Film angeordnet sind und auf dem Film mit Hilfe von Leiterbändchen 4 gehalten sind. Die freien Enden 3 der Leiterbändchen 4 sind auf dem Film 1 befestigt. In dieser Form sind die IC's 5 in einfacher Weise maschinell verarbeitbar. Als nächstes wird, wie ebenfalls in Figur 1 dargestellt, entsprechend den Stanzkanten 6 das in Figur 2 gezeigte Teil ausgestanzt. Dieses Teil zeigt wiederum den IC 5 in der Öffnung 9, der nunmehr in einem Rahmen 7 durch die Bändchen 4 gehalten ist. Die auf dem Rahmen 7 befindlichen Teile der Leiterbändchen sind mit 8 bezeichnet.

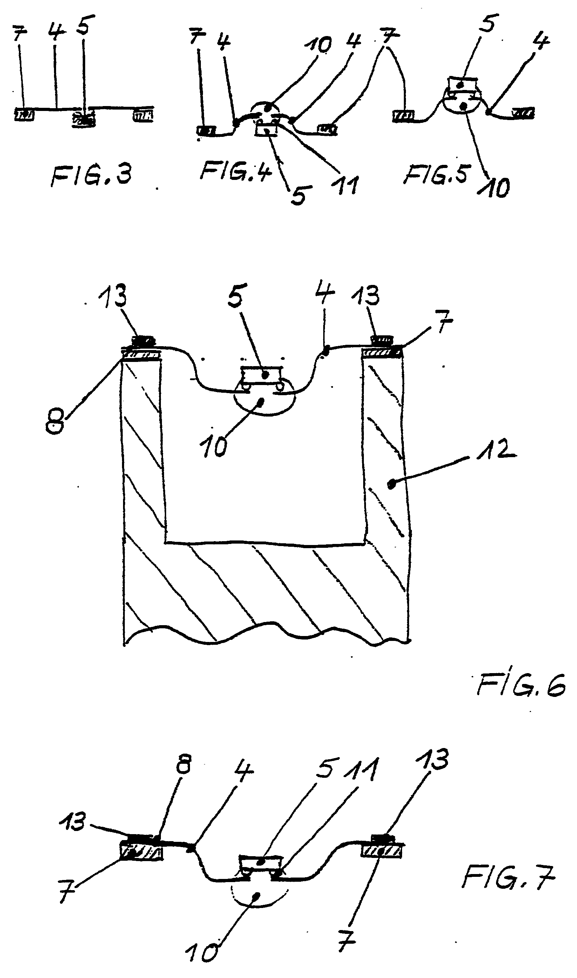

In den Figuren 3, 4 und 5 sind verschiedene Möglichkeiten dargestellt, wie der IC 5 durch die Leiterbändchen 4 innerhalb des Rahmens freitragend aufgehängt sein kann.

In der Figur 3 befindet sich der IC 5 an der Ebene des Rahmens 7 und die Bändchen 4 verlaufen im wesentlichen geradlinig.

In dem Ausführungsbeispiel nach Figur 4 befindet sich der IC 5 wiederum in der Ebene des Rahmens 7, wobei jedoch die Leiterbändchen 4 an der unteren Fläche des Rahmens 7 befestigt sind, und die Bändchen 4 gekröpft verlaufen. Die Bändchen 4 sind in bekannter Weise an entsprechenden Stelle des IC 5 angebondet. 11 zeigt die Bondbumps. Durch eine Kunststoffverguß 10 sind die Bondstellen mechanisch entlastet.

In Figur 5 ist ein Ausführungsbeispiel dargestellt, bei dem der IC 5 sich innerhalb der Ebene des Rahmens 7 befindet. Die Bändchen 4 sind wiederum gekröpft und die Bondstellen über einen Kunststoffverguß 10 mechanisch entlastet.

Die Figur 6 zeigt nun einen Verfahrensschritt gemäß der Erfindung, bei welchem der Rahmen 7 von einem pneumatischen Saugwerkzeug 12 gehalten ist, und zwar in der Weise, daß die freie Oberfläche des Rahmens 7 angesaugt gehalten ist und sich die Enden 8 der Leiterbändchen 4 an der Oberseite des Rahmens 7 befinden, wobei auch das Werkzeug 12 die Anordnung so hält, daß die Enden 8 auf der Oberfläche des Rahmens 7 von oben her frei zugänglich sind. Auf diese Enden 8 wird nun entweder durch Siebdruck oder aber mit einer Dosierspritze in genau dosierter Menge und Größe klebfähiger, leitfähiger Klebstoff 13 aufgebracht. Die weiteren Teile sind wie in den anderen Figuren mit gleichen Ziffern bezeichnet.

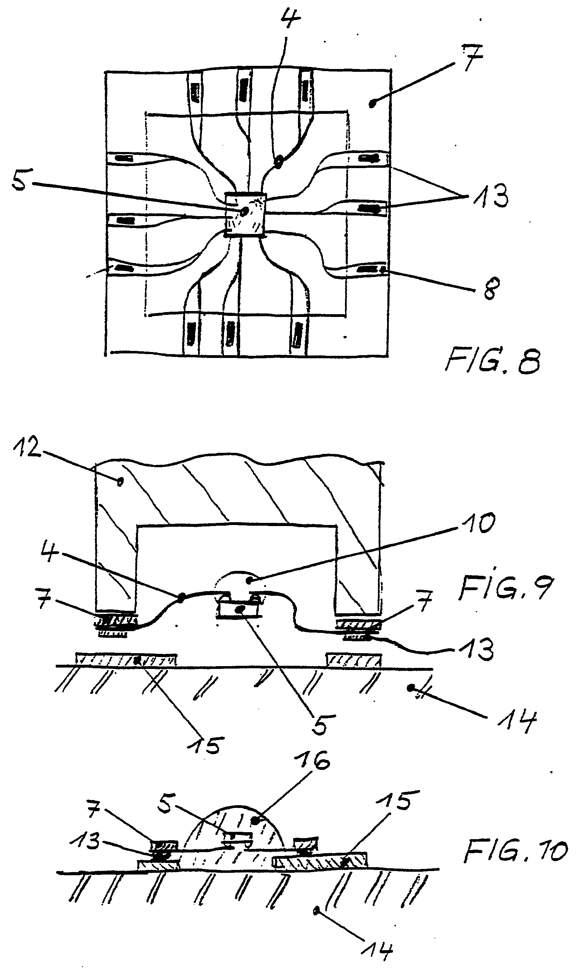

In der Figur 7 ist dieser Rahmen mit dem entsprechend gehalterten IC 5 unddem aufgebrachten Klebstoffstellen 13 nochmals ohne das Werkzeug 12 im Querschnitt dargestellt.

In der Figur 8 ist das gleiche Teile in der Aufsicht von oben dargestellt und man sieht die aufgebrachten Klebstoffpunkte 13 aus leitfähigem Kleber, die sich nur auf den Oberflächenteilen 8 der Leiterbändchen befinden, die auf der Oberfläche des Isolierrahmens 7 angeordnet sind.

Die Figur 9 zeigt nun in einem auf ein gläsernes Substrat 14 einer FK-Zelle aufgebracht wird. Das Substrat 14 ist bevorzugt eine entsprechende Glasplatte einer FK-Zelle und trägt Leiterbahnen 15, die als elektrische Zuführungen aus der FK-Zelle herausgeführt sind. Das Werkzeug 12 befindet sich in einem umgedrehten Zustand, so daß nunmehr die aufgebrachten Klestoffpunkte 13 auf den Leiterbändchen 4 nach unten zeigen. Das Werkzeug 12 drückt nun diese Anordnung mit den Klebstoffpunkten 13 so auf das Substrat 14, daß die Klebstoffpunkte 13 auf die Leiterbahnen 15 aufgepreßt und angeklebt werden. Da der Klebstoff ein leitfähiger Kleber ist, wird dadurch gleichzeitig eine elektrische Kontaktierung hergestellt, die nach Aushärtung des Klebers gleichzeitig eine feste Verankerung des IC's darstellt.

Die Figur 10 zeigt nun nochmals ein Substrat 14 aus Glas mit den Leiterbahnen 15, auf welchen der IC 5 in der vorbeschriebenen Weise aufgeklebt ist. Durch einen weiteren Kunststoffverguß 16 aus isolierendem Material kann eine weitere mechanische Entlastung der Klebstellen erreicht werden und eine erhöhte Schocksicherung für den Aufbau erzielt werden. Die IC's stellen integrierte Ansteuerschaltkreise für die FK-Zelle dar.

## Patentansprüche

1. Verfahren zum Aufbringen eines in der Öffnung (9) eines Isolierrahmens (7) mittels Leiterbändchen (4) aufhängten IC (5) auf die Oberfläche eines mit elektrischen Leiterbahnen (15) versehenen Substrats (14), in der Weise, daß ein elektrischer Kontakt zwischen den Leiterbahnen (15) des Substrats und den Leiterbändchen (14) des IC hergestellt wird, wobei auf die Teile der Leiterbändchen, die sich auf der Oberfläche des Rahmens befinden, ein leitfähiger Kleber (13) aufgetragen wird und dann der Rahmen mit dem IC und den mit Kleber versehenen Leiterbändchen auf das Substrat überführt und dort so positioniert wird, daß eine elektrisch leitende Klebeverbindung (13) zwischen den Leiterbändchen (4) des IC (5) und den entsprechenden Leiterbahnen (15) des Substrats (14) hergestellt wird, dadurch gekennzeichnet, daß zum Auftragen des elektrisch leitenden Klebers (13) der Rahmen (7) mittels eines Haltewerkzeuges (12) so gehalten wird, daß die Leiterbändchen sich auf der Oberseite des Rahmens (7) befinden und daß dann der leitfähige Kleber mittels einer Dosierspritze oder mittels Siebdruck lediglich nur in dem Oberflächenbereich der Leiterbändchen aufgebracht wird, der durch den Rahmen unterstützt ist.

2. Verfahren nach Anspruch 1, dadurch gekennzeichnet, daß die Überführung und Positionierung des Rahmens auf das Substrat mit dem gleichen Haltewerkzeug (12) erfolgt, das zur Halterung während des Aufbringens des Klebers (13) verwendet wird.

3. Verfahren nach Anspruch 1 oder Anspruch 2, dadurch gekennzeichnet, daß als Substrat (14) mit Leiterbahnen (15) ein Substrat einer Flüssigkristall-Anzeigezelle verwendet wird.

4. Verfahren nach Anspruch 3, gekennzeichnet durch die Verwendung eines Substrats aus Glas.

5. Verfahren nach einem der Ansprüche 1 bis 4, dadurch gekennzeichnet, daß die Halterung des Rahmens (7) mit einem Haltewerkzeug (12) erfolgt, das den Rahmen mittels Unterdruck angesaugt festhält.

## Claims

1. Method for the mounting of an integrated circuit (5), which is suspended by means of conductor ribbons (4) in the opening (9) of an insulating frame (7), on the surface of a substrate (14) provided with electrical conductor tracks (15) in such a manner that an electrical contact is produced between the conductor tracks (15) of the substrate and the conductor ribbons (4) of the integrated circuit, wherein a conductive adhesive substance (13) is applied onto those parts of the conductor ribbons, which are situated on the surface of the frame, and the frame with the integrated circuit, and the conductor ribbons provided with adhesive substance is then transferred onto the substrate and there so positioned that an electrically conducting adhesive connection (13) is produced between the conductor ribbons (4) of the integrated circuit (5) and the corresponding conductor tracks (15) of the substrate (14), characterised thereby, that the frame (7) is so retained by means of a holding tool (12) for the application of the electrically conducting adhesive substance (13) that the conductor ribbons are disposed on the upper side of the frame (7) and that the conductive adhesive substance is then applied by means of a metering syringe or by means of screen printing merely only in that surface region of the conductor ribbons, which is supported by the frame.

2. Method according to claim 1, characterised thereby, that the transfer and the positioning of the frame onto the substrate takes place with the same holding tool (12), which is used for the retention during the application of the adhesive substance (13).

3. Method according to claim 1 or claim 2, characterised thereby, that a substrate of a liquid crystal indicator cell is used as substrate (14) with conductor tracks (15).

4. Method according to claim 3, characterised by the use of a substrate of glass.

5. Method according to one of the claims 1 to 4, characterised thereby, that the retention of the frame (7) takes place with a holding tool (12), which retains the frame under suction by means of underpressure.

## Revendications

1. Procédé pour mettre en place un circuit intégré (5), lequel est suspendu par de petites bandes conductrices (4) dans l'ouverture (9) d'un cadre isolant (7), sur la surface d'un substrat (14) pourvu de pistes électriques conductives (15), de manière qu'un contact électrique soit établi entre les pistes conductives (15) du substrat et les bandes conductrices (4) du circuit intégré, procédé selon lequel on applique une colle conductrice (13) sur les portions des bandes conductrices situées sur la surface du cadre puis on transfère le cadre avec le circuit intégré et les bandes conductrices, dotées de colle, au substrat, où on positionne le cadre de manière qu'une liaison adhésive (13) électriquement conductrice soit établie entre les bandes conductrices (4) du circuit intégré (5) et les pistes conductives (15) correspondantes du substrat (14), caractérisé en ce que, pour appliquer la colle (13) électriquement conductrice, on maintient le cadre (7), au moyen d'un outil de préhension (12), de sorte que les bandes conductrices se trouvent sur le dessus du cadre (7), et on applique ensuite la colle conductrice, au moyen d'un pistolet doseur ou par sérigraphie, dans la seule portion de surface des bandes conductrices qui est soutenue par le cadre.

2. Procédé selon la revendication 1, caractérisé en ce que le transfert et le positionnement du cadre sur le substrat s'effectuent avec le même outil de préhension (12) que celui utilisé pour maintenir le cadre pendant l'application de la colle (13).

3. Procédé selon la revendication 1 ou 2, caractérisé en ce que le substrat (14) portant les pistes conductives (15) est un substrat d'une cellule d'affichage à cristaux liquides.

4. Procédé selon la revendication 3, caractérisé par l'utilisation d'un substrat en verre.

5. Procédé selon une des revendications 1 à 4, caractérisé en ce que le cadre (7) est maintenu à l'aide d'un outil de préhension (12) qui maintient le cadre par aspiration, à l'aide d'une dépression.

EP 0 226 050 B1

FIG.1

FIG.2

EP 0 226 050 B1

FIG.3    FIG.4    FIG.5

FIG.6

FIG.7

FIG. 8

FIG. 9

FIG. 10